Europäisches Patentamt

European Patent Office

Office européen des brevets

(19)

(11) Veröffentlichungsnummer: **0 123 075**
**B1**

# (12) EUROPÄISCHE PATENTSCHRIFT

(45) Veröffentlichungstag der Patentschrift:
04.02.87

(21) Anmeldenummer: 84102395.5

(22) Anmeldetag: 06.03.84

(51) Int. Cl.⁴: **G 01 N 24/06, G 01 N 24/08**

(54) Gerät zur Erzeugung von Bildern und ortsaufgelösten Spektren eines Untersuchungsobjektes mit magnetischer Kernresonanz.

(30) Priorität: 21.03.83 DE 3310160

(43) Veröffentlichungstag der Anmeldung:
31.10.84 Patentblatt 84/44

(45) Bekanntmachung des Hinweises auf die Patenterteilung:
04.02.87 Patentblatt 87/6

(84) Benannte Vertragsstaaten:
DE FR GB NL

(56) Entgegenhaltungen:
EP-A-0 011 335
EP-A-0 073 375
DE-A-2 951 018

(73) Patentinhaber: **Siemens Aktiengesellschaft Berlin und München, Wittelsbacherplatz 2, D-8000 München 2 (DE)**

(72) Erfinder: **Oppelt, Arnulf, Dr., Am Eichengarten 7, D-8520 Erlangen (DE)**

## Beschreibung

Die Erfindung betrifft ein Gerät zur Erzeugung von Bildern und ortsauflösenden Spektren eines Untersuchungsobjektes mit magnetischer Kernresonanz, bei dem Magnetspulen zum Anlegen von Grund- und Gradientenfeldern an das Untersuchungsobjekt und zum Erfassen der Auslenkung der Atomkerne des Untersuchungsobjektes aus ihrer Gleichgewichtslage durch einen hochfrequenten, magnetischen Anregungsimpuls vorhanden sind und das eine Bildrekonstruktionseinrichtung für ein Bild bzw. ortsaufgelöste Kernresonanzspektren in einem vorbestimmten Meßfeld aufweist, sowie mit einem Kryostaten zur Aufnahme vorwiegend supraleitender Grundfeldspulen, der einen Vakuummantel aufweist.

Bei bekannten Geräten dieser Art führt das Ein- und Ausschalten des Stromes in den Gradientenspulen zu Geräuschentwicklungen, durch die der von diesen Spulen umgebene Patient belästigt werden kann. Der Grund für diese Geräuschentwicklungen ist der beim Ein- und Ausschalten des Gradientenstromes bei Anwesenheit des magnetischen Gleichfeldes auf die elektrischen Leiter wirkende Ruck, der das bei den bekannten Geräten vorhandene Trägerrohr der Gradientenspulen zum Schwingen anregt. Dieser Ruck (Kraftänderung pro Zeit) ist um so größer, je kürzer die An- und Abschaltzeit des Gradientenstromes, je höher der Gradientenstrom und je höher das Grundfeld ist. Zur Erzeugung qualitativ hochwertiger Kernspintomogramme werden jedoch Anforderungen in dieser Richtung gestellt.

Der Erfindung liegt die Aufgabe zugrunde, ein Gerät der eingangs genannten Art so auszubilden, daß die Geräuschentwicklung aufgrund von auf die elektrischen Leiter der Spulen einwirkenden Kraftstößen gegenüber dem Stand der Technik wesentlich reduziert ist.

Diese Aufgabe ist erfindungsgemäß dadurch gelöst, daß bei Anwendung von Grundfeldmagneten mit supraleitenden Spulen, die mit flüssigem Helium gekühlt sind und sich zur Wärmeisolation in einem Kryostaten mit Vakuummantel befinden, die Gradientenspulen räumlich isoliert in diesem Vakuummantel angeordnet sind.

Durch räumlich möglichst isolierte Anordnung derselben wird die großflächige Abstrahlung von Schall verhindert. Die Übertragung von Körperschall auf den Kryostaten kann durch Aufhängungen mit genügend Eigendämpfung gering gehalten werden.

Gemäß einer Weiterbildung der Erfindung kann die Anordnung der Gradientenspulen im Vakuummantel des Kryostaten kombiniert werden mit der Anordnung der Hochfrequenz-Sende- und -Empfangsspulen in ebenfalls diesem Mantel. In diesem Fall bleibt die Patientenöffnung völlig frei. Abdampfendes Kühlmittel (Helium oder Stickstoff) kann zur Kühlung der Gradientenspulen und des Hochfrequenz-Spulensystems verwendet werden, wodurch das thermische Rauschen vermindert wird.

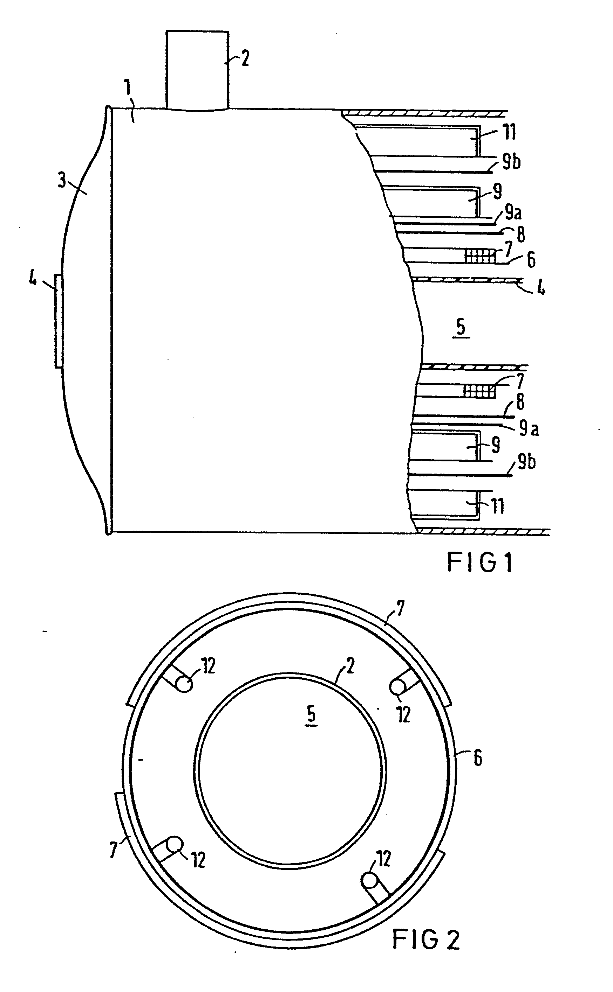

Die Erfindung ist nachfolgend anhand zweier in den Figuren 1 und 2 dargestellter Ausführungsbeispiele näher erläutert.

In der Figur 1 ist der Kryostat eines supraleitenden Magneten schematisch dargestellt und ergänzt durch die Gradientenspulen 7. 1 stellt das Vakuumgehäuse dar, 2 den Turm mit den Zuführungen für die flüssigen Gase und den Stromanschlüssen. Das Gehäuse 1 ist mit einem Dackel 3 versehen, der in der Mitte ein Kunststoffrohr 4 trägt, das den Patientenraum 5 vom Vakuum trennt. In der Zeichnung ist der Kryostat aufgeschnitten, so daß man die Innenteile erkennen kann. 6 stellt ein eingebrachtes Tragrohr auf Kunststoff mit den Gradientenspulen 7 dar, 8 ein Kühlschild, das wärmeleitend mit dem Stickstofftank 11 verbunden ist, 9a und 9b weitere Kühlschilde, welche Wärmestrahlung auf den Heliumtank 9 vermindern. Die Grundfeldspulen befinden sich im Heliumtank 9. Aufgrund der Anordnung der Gradientenspulen 7 im Vakuum zwischen dem Gehäuse 1 und dem Kunststoffrohr 4 ist die Geräuschentwicklung bei der Ein- und Ausschaltung dieser Gradientenspulen gegenüber dem Stand der Technik wesentlich reduziert.

Bei dem im Querschnitt dargestellten Ausführungsbeispiel gemäß Figur 2 ist der Kryostat durch ein Hochfrequenz-Sende- und -Empfangssystem, vorzugsweise gemäß EP-A-73 375, ergänzt. Hierzu sind auf der Innenseite des Tragrohres 6 für die Gradientenspulen 7 auch noch Stäbe 12 gehaltert, die die Hochfrequenz-Sende- und -Empfangsantennen bilden. Das Tragrohr 6 ist bei dem Ausführungsbeispiel gemäß Figur 2 auf seiner Innenseite mit einer leitfähigen Kupfer- oder Silberschicht zur Abschirmung überzogen. Alternativ können jedoch auch konventionelle Hochfrequenzspulen, vorzugsweise Sattelspulen, verwendet werden.

## Patentansprüche

1. Gerät zur Erzeugung von Bildern und ortsaufgelösten Spektren eines Untersuchungsobjektes mit magnetischer Kernresonanz, bei dem Magnetspulen zum Anlegen von Grund- und Gradientenfeldern an das Untersuchungsobjekt und zum Erfassen der Auslenkung der Atomkerne des Untersuchungsobjektes aus ihrer Gleichgewichtslage durch einen hochfrequenten, magnetischen Anregungsimpuls vorhanden sind und das eine Bildrekonstruktionseinrichtung für ein Bild in einem vorbestimmten Meßfeld aufweist, sowie mit einem Kryostaten zur Aufnahme der Grundfeldspulen, der einen Vakuummantel (1, 4) aufweist, **dadurch**

gekennzeichnet, daß die Gradientenspulen (7) räumlich isoliert in diesem Vakuummantel (1, 4) angeordnet sind.

2. Gerät nach Anspruch 1, dadurch gekennzeichnet, daß auch die Hochfrequenz-Sende- und -Empfangsspulen (12) im Vakuummantel (1, 4) angeordnet sind.

3. Gerät nach Anspruch 1 oder 2, dadurch gekennzeichnet, daß die Gradientenspulen (7) von abdampfendem Helium, das zur Kühlung der supraleitenden Grundfeldspulen dient, gekühlt sind, um ihre thermische Belastung gering zu halten.

4. Gerät nach Anspruch 1 oder 2, dadurch gekennzeichnet, daß die Gradientenspulen (7) von abdampfendem flüssigem Stickstoff, der zur Kühlung von Strahlungsschilden im Kryostaten dient, gekühlt sind, um die thermische Belastung gering zu halten.

5. Gerät nach einem der Ansprüche 1 bis 4, dadurch gekennzeichnet, daß die Hochfrequenzspulen (12) entweder von abdampfendem Helium oder Stickstoff gekühlt werden, um ihr thermisches Rauschen zu reduzieren.

## Claims

1. Apparatus for producing images and spatially resolved spectra of an object under examination by means of nuclear magnetic resonance, wherein there are arranged magnetic coils for applying fundamental and gradient fields to the object under examination and for detecting the deflection of the atomic cores of the object under examination from its position of equilibrium due to a high-frequency, magnetic excitation pulse and which has an image construction device for an image in a predetermined measuring field and a cryostat which serves to house the fundamental field coils and has a vacuum jacket (1, 4), characterised in that the gradient coils (7) are arranged so as to be spatially insulated in said vacuum jacket (1, 4).

2. Apparatus as claimed in claim 1, characterised in that the high-frequency transmitting and receiving coils (12) are likewise arranged in the vacuum jacket (1, 4).

3. Apparatus as claimed in claim 1 or 2, characterised in that the gradient coils (7) are cooled by evaporating helium, which serves to cool the superconductive fundamental field coils, in order to keep their thermal stress low.

4. Apparatus as claimed in claim 1 or 2, characterised in that the gradient coils (7) are cooled by evaporating liquid nitrogen, which serves to cool radiation shields in the cryostat, in order to keep the thermal stress low.

5. Apparatus as claimed in one of claims 1 to 4, characterised in that the high-frequency coils (12) are cooled by either evaporating helium or nitrogen, in order to reduce their thermal background noise.

## Revendications

1. Appareil pour produire des images et des spectres à résolution locale d'un objet d'examen, au moyen de la résonance magnétique nucléaire, et dans lequel il est prévu des bobines magnétiques servant à appliquer un champ de base et des champs irrotationnels, à l'objet d'examen et à détecter la déviation des noyaux atomiques de l'objet d'examen à partir de leur position d'équilibre sous l'effet d'une impulsion magnétique d'excitation à haute fréquence, et qui comporte un dispositif de reconstitution d'images pour une image dans un champ de mesure prédéterminé, ainsi qu'un cryostat servant à loger les bobines produisant le champ de base et qui comporte une enceinte à vide (1, 4), caractérisé en ce que les bobines de gradient (7) sont disposées en étant isolées spatialement dans cette enceinte à vide (1, 4).

2. Appareil suivant la revendication 1, caractérisé par le fait que les bobines d'émission et de réception à haute fréquence (12) sont également disposées dans l'enceinte à vide (1, 4).

3. Appareil suivant la revendication 1 ou 2, caractérisé par le fait que les bobinesde gradient (7) sont refroidies par de l'hélium s'évaporant, qui sert à refroidir les bobines supraconductrices produisant le champ de base, afin de maintenir à une faible valeur leur contrainte thermique.

4. Appareil suivant la revendication 1 ou 2, caractérisé par le fait que les bobinesde gradient (7) sont refroidies par de l'azote liquide s'évaporant, qui est utilisé pour le refroidissement de boucliers de protection contre le rayonnement dans le cryostat, afin de maintenir à une faible valeur la contrainte thermique.

5. Appareil suivant l'une des revendications 1 à 4, caractérisé par le fait que les bobines à haute fréquence (12) sont refroidies par de l'hélium ou par de l'azote s'évaporant, afin de réduire leur bruit thermique.

FIG 1

FIG 2